# EUROPÄISCHE PATENTSCHRIFT

(11) **EP 2 209 129 B1**
(45) Veröffentlichungstag und Bekanntmachung des Hinweises auf die Patenterteilung: **07.03.2012**
(21) Anmeldenummer: 09290031.5
(22) Anmeldetag: 15.01.2009
(51) Int. Cl.: H01F 6/04, H01F 6/00, H01F 6/06, H01L 39/16, H01B 12/02

(54) **Anordnung zur Strombegrenzung**
System for limiting current
Agencement de limitation de courant

(43) Veröffentlichungstag der Anmeldung: 21.07.2010
(73) Patentinhaber: Nexans, 75008 Paris (FR)
(72) Erfinder: Soika, Rainer, 30559 Hannover (DE); Stemmle, Mark, 30161 Hannover (DE)
(74) Vertreter: Döring, Roger

(56) Entgegenhaltungen:
- EP-A- 0 620 630
- EP-A- 1 681 731
- EP-A- 1 717 821
- DE-A1- 4 418 050
- FR-A- 2 878 654
- US-A- 5 140 290

## Beschreibung

Die Erfindung bezieht sich auf eine Anordnung zur Strombegrenzung mit einem supraleitfähigen Kabel, das in einem Kryostat angeordnet ist, der eine Außenwand aufweist, welche aus zwei konzentrisch zueinander angeordneten, metallischen Rohren besteht, zwischen denen eine Vakuumisolierung angebracht ist, und der einen Freiraum zum Durchleiten eines Kühlmittels umschließt, in dem das supraleitfähige Kabel angeordnet ist (EP 1 681 731 A1).

Ein supraleitfähiges Kabel hat in heutiger Technik elektrische Leiter aus einem Verbundwerkstoff, welcher keramisches Material enthält, das bei ausreichend tiefen Temperaturen in den supraleitfähigen Zustand übergeht. Der elektrische Gleichstromwiderstand eines entsprechend aufgebauten Leiters ist bei ausreichender Kühlung Null, solange eine bestimmte Stromstärke, die kritische Stromstärke, nicht überschritten wird. Geeignete keramische Materialien sind beispielsweise YBCO (Yttrium-Barium-Kupfer-Oxid) oder BSCCO (Wismut-Strontium-Kalzium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

Eine Anordnung zur Strombegrenzung, wie sie eingangs beschrieben wird, kann als eine Art Sicherung in eine beliebige Kabelstrecke oder auch eine Schaltanlage als Übertragungsstrecke eingebaut werden, über die bzw. in der mehr oder weniger hohe Ströme übertragen werden. Sie soll verhindern, daß bei einem Kurzschluß auf der Übertragungsstrecke wesentliche Beschädigungen derselben eintreten. Durch eine im Kurzschlußfall auftretende wesentliche Erhöhung der elektrischen Impedanz der Anordnung wird ein Mechanismus ausgelöst, durch welchen die Übertragungsstrecke von der Speisestromquelle abgetrennt wird. Die Übertragungsstrecke kann nach Behebung der Ursache des Kurzschlusses wieder eingeschaltet werden, ohne daß an der strombegrenzenden Anordnung etwas geändert werden muß.

Anordnungen zur Strombegrenzung unter Einsatz von supraleitfähigem Material sind auch aus den im Folgenden genannten Druckschriften bekannt.

Die in der US 5 140 290 beschriebene Anordnung besteht aus einer auf einen Hohlzylinder aus supraleitfähigem Material aufgewickelten Kupferspule. In dem Hohlzylinder ist ein aus weichmagnetischem Material, beispielsweise Eisen, bestehender Kern angebracht.

Die DE 44 18 050 A1 beschreibt einen als induktiven Strombegrenzer einsetzbaren Hochtemperatursupraleiter. Der hohlzylindrisch ausgeführte Hochtemperatursupraleiter umschließt einen weichmagnetischen Kern. Er ist von einem Kühler mit einem Vakuumgefäß umgeben, das sich im Inneren einer Drosselspule befindet.

Der supraleitfähige Strombegrenzer nach der EP 0 620 630 A1 weist einen doppelwandigen, mit Stickstoff gefüllten Kühler auf, der in seinem zylindrischen Inneren einen weichmagnetischen Kern umschließt. In der Kühlflüssigkeit des Kühlers befindet sich ein hohlzylindrischer supraleitfähiger Körper. Er bildet eine Abschirmung des Kerns gegen das Magnetfeld einer außen um den Kühler gewickelten Spule.

Die eingangs erwähnte EP 1 681 731 A1 beschreibt eine supraleitfähige Komponente zur Strombegrenzung. Sie besteht aus einem zylindrischen Träger aus supraleitfähigem Material, um den ein supraleitfähiger Leiter herumgewickelt ist. Parallel zu demselben ist ein Normalleiter geschaltet. Mehrere solcher Komponenten werden zur Herstellung eines Strombegrenzers elektrisch in Reihe geschaltet.

Der Erfindung liegt die Aufgabe zugrunde, die eingangs geschilderte Anordnung einfacher zu gestalten.

Diese Aufgabe wird gemäß der Erfindung dadurch gelöst,
- daß der Kryostat eine einen zylindrischen Hohlraum umschließende Innenwand aufweist, die ebenfalls aus zwei konzentrisch zueinander angeordneten, metallischen Rohren besteht, zwischen denen eine Vakuumisolierung angeordnet ist, und die innerhalb der Außenwand liegt und durch den Freiraum von derselben getrennt ist,
- daß das als Kabel mit kaltem Dielektrikum ausgeführte supraleitfähige Kabel, welches einen supraleitfähigen Leiter, ein denselben umgebendes Dielektrikum und einen über demselben angeordneten supraleitfähigen Schirm aufweist, wendelförmig um die Innenwand herumgewickelt ist und
- daß in dem zylindrischen Hohlraum ein Eisenkern angeordnet ist.

Diese, einen supraleitfähigen Strombegrenzer darstellende Anordnung wird beispielsweise so hergestellt, daß ein supraleitfähiges Kabel mit kaltem Dielektrikum um die Innenwand des Kryostats herumgewickelt wird, welche einen im zylindrischen Hohlraum befindlichen Eisenkern umschließt. Der Eisenkern befindet sich in dem Hohlraum außerhalb des Kabelkryostats. Er wird also von dem im Freiraum befindlichen Kühlmittel nicht beeinflußt, sondern bleibt auch während des Betriebs der Anordnung auf Raumtemperatur. Die im Falle eines Kurzschlusses auf der Übertragungsstrecke, in welche die Anordnung eingebaut ist, entstehende Kurzschlußleistung wird größtenteils in dem Eisenkern aufgenommen, der entsprechend dimensioniert sein muß. Das supraleitfähige Kabel der Anordnung ist so ausgelegt, daß die kritische Stromstärke des Schirms desselben kleiner ist als die kritische Stromstärke des Leiters. Der Schirm wird zweckmäßig so festgelegt, daß seine kritische Stromstärke der Stromstärke entspricht, ab der eine Kurzschlußstrombegrenzung einsetzen soll. Der Leiter des Kabels wird mit Vorteil so aufgebaut, daß sowohl eine Temperaturerhöhung im Kurzschlußfall als auch Wechselstromverluste im Dauerbetrieb so gering sind, daß ein verlustarmer Dauerbetrieb und kurze Rückkühlzeiten gewährleistet sind.

Bei einem supraleitfähigen Kabel mit kaltem Dielektrikum, wie es in der Anordnung eingesetzt ist, wird der im Schirm fließende Strom vom Leiter induziert. Er hat in der Regel die gleiche Amplitude wie der Strom im Leiter, ist gegenüber demselben aber um 180° phasenverschoben. Solange der supraleitfähige Schirm dabei weit unterhalb seiner kritischen Stromstärke betrieben wird, ist kein ohmscher Spannungsabfall am Schirm festzustellen. Die Strombegrenzung bei vorliegender Anordnung erfolgt nun dadurch, daß bei Erreichen der kritischen Stromstärke im Schirm eine weitere Erhöhung der Stromstärke in demselben kaum mehr stattfindet. Das vom Leiter erzeugte Magnetfeld wird dann nicht mehr abgeschirmt. Es breitet sich daher auch außerhalb des Schirms und insbesondere im Eisenkern aus, um den herum, unter Zwischenschaltung der Innenwand des Kryostats, um das das supraleitfähige Kabel angeordnet ist. Dadurch wird direkt eine wesentliche Erhöhung der Induktivität des Leiters bewirkt, also eine Erhöhung seiner elektrischen Impedanz. Der über den Leiter fließende Kurzschlußstrom wird damit merklich und schnell begrenzt. Die bei bekannten supraleitfähigen Kabeln durch einen hohen Kurzschlußstrom auftretende Erwärmung ist dementsprechend wesentlich vermindert. Es ist dadurch sichergestellt, daß die Anordnung durch einen Kurzschlußstrom nicht beschädigt wird. Sie ist nach Beseitigung der Ursache des Kurzschlusses auf der Übertragungsstrecke ohne irgendwelche Maßnahmen wieder funktionsfähig.

Ein Ausführungsbeispiel des Erfindungsgegenstandes ist in den Zeichnungen dargestellt.

Es zeigen:
Fig. 1 einen Längsschnitt durch eine Anordnung nach der Erfindung.
Fig. 2 einen Schnitt durch Fig. 1 längs der Linie II - II.
Fig. 3 einen Schnitt durch ein in der Anordnung einsetzbares supraleitfähiges Kabel.

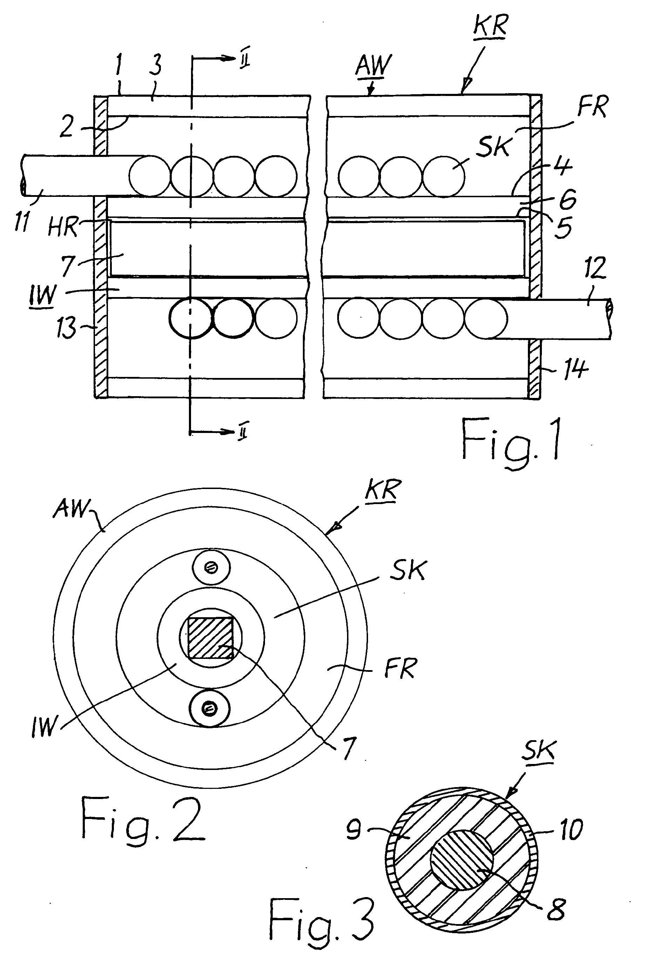

In Fig. 1 ist im Schnitt ein Kryostat KR dargestellt, der eine Außenwand AW und eine Innenwand IW aufweist. Die Außenwand AW besteht aus zwei konzentrisch zueinander angeordneten metallischen Rohren 1 und 2, zwischen denen eine Vakuumisolierung 3 angebracht ist. Die mit Abstand zur Außenwand AW angeordnete Innenwand IW besteht ebenfalls aus zwei konzentrisch zueinander angeordneten metallischen Rohren 4 und 5, zwischen denen eine Vakuumisolierung 6 angebracht ist. Die Rohre 1 und 2 sowie 4 und 5 bestehen mit Vorteil aus Edelstahl. Sie haben mit Vorteil eine für die Stabilität der Anordnung ausreichende, relativ dicke Wandstärke und können quer zu ihrer Längsrichtung gewellt sein. In den Fig. 1 und 2 sind die Rohre 1 und 2 sowie 4 und 5 der Einfachheit halber nur durch einfache Linien dargestellt.

Zwischen der Außenwand AW und der vorzugsweise koaxial zu derselben verlaufenden Innenwand IW des Kryostats befindet sich ein Freiraum FR zur Durchleitung eines Kühlmittels. In dem Freiraum FR ist ein supraleitfähiges Kabel SK angeordnet, das um die Innenwand IW herumgewickelt ist. Der Aufbau des Kabels SK geht aus Fig. 3 hervor. Die Innenwand IW umschließt einen zylindrischen Hohlraum HR, in dem ein Eisenkern 7 angeordnet ist. Er erstreckt sich über die ganze Länge der Anordnung und hat gemäß der zeichnerischen Darstellung in Fig. 2 einen quadratischen Querschnitt. Der Eisenkern 7 kann aber auch eine andere Querschnittsform haben, beispielsweise kreisrund. Er hat mit Vorteil eine relative Permeabilität µᵣ, die größer als 10 ist.

Die Anordnung nach der Erfindung wird für ihren Betrieb in eine Übertragungsstrecke für elektrischen Strom eingebaut. Dazu werden an die aus dem Kryostat KR druckdicht herausgeführten Enden 11 und 12 des Kabels SK entsprechende Kabel oder Kontakte der Übertragungsstrecke angeschlossen. Die Abmessungen der Anordnung insgesamt sind abhängig von der Spannungsebene, in der die Übertragungsstrecke betrieben wird. Sie können denen von handelsüblichen Transformatoren entsprechen.

Das supraleitföhige Kabel SK ist ein Kabel mit kaltem Dielektrikum. Es besteht aus einem supraleitfähigen Leiter 8, einem denselben umgebenden Dielektrikum 9 und einem außen an demselben anliegenden supraleitfähigen Schirm 10. Als supraleitfähiges Material ist für den Leiter 8 mit Vorteil BSCCO eingesetzt. Es könnte aber auch YBCO verwendet werden, wenn der Leiter 8 durch normalleitendes Material stabilisiert ist. Der Leiter 8 ist so aufgebaut, daß seine kritische Stromstärke höher als die kritische Stromstärke des Schirms 10 ist. Der Schirm 10 besteht mit Vorteil aus YBCO und ist vorzugsweise nicht durch einen Normalleiter stabilisiert. Die Höhe der jeweiligen kritischen Stromstärken hängt von der Spannungsebene ab, in der die mit der Anordnung ausgerüstete Übertragungsstrecke betrieben wird.

Zur Herstellung der Anordnung nach Fig. 1 wird das supraleitfähige Kabel SK um die Innenwand IW des Kryostats KR herumgewickelt. Seine beiden Enden 11 und 12 werden für Kontaktierungszwecke mit Vorteil geradlinig abgebogen, so daß sie in der fertigen Anordnung aus dem Kryostat KR herausragen. In den zylindrischen Hohlraum HR wird danach oder auch vorher der Eisenkern 7 eingeschoben. Die so bestückte Innenwand IW wird dann in die Außenwand AW eingebracht und in einer möglichst koaxialen Form in derselben fixiert. Dazu können beispielsweise Endplatten 13 und 14 verwendet werden, mittels derer der Kryostat KR bzw. dessen Freiraum FR hermetisch abgeschichtet wird. Die Enden 11 und 12 des Kabels SK werden druckdicht durch die Endplatten 13 und 14 hindurchgeführt. Die Endplatten 13 und 14 werden auch mit Anschlußelementen zum Ein- und Abführen eines Kühlmittels ausgerüstet.

Die so fertiggestellte Anordnung wird im Einsatzfall in eine Übertragungsstrecke für elektrischen Strom eingeschaltet. Das supraleitfähige Kabel SK ist dann Teil dieser Übertragungsstrecke. Durch einen auf derselben auftretenden Kurzschluß entsteht ein Strom mit erhöhter Stromstärke. Wenn diese höher als die kritische Stromstärke des Schirms 10 des Kabels SK ist, wird dessen elektrischer Widerstand schlagartig wesentlich erhöht, was eine schlagartige Erhöhung der elektrischen Impedanz der Anordnung zur Folge hat. Das wird in einer entsprechenden Überwachungsschaltung registriert und führt zur sofortigen Abschaltung der Übertragungsstrecke. Die Ursache für den Kurzschluß kann dann beseitigt werden.

Durch die erhöhte, die kritische Stromstärke des Schirms 10 übersteigende Stromstärke verliert der Schirm 10 seine abschirmende Funktion, so daß das Magnetfeld des Leiters 8 in den Eisenkern 7 eindringt. Der elektrische Widerstand des Leiters 8 und damit des Kabels SK wird dadurch - wie schon erwähnt - schlagartig wesentlich erhöht, so daß die Übertragungsstrecke abgeschaltet wird. Das Kabel SK und damit die gesamte Anordnung werden dabei nicht beschädigt. Die kurzzeitig auftretende Erwärmung des Kühlmittels ist gering. Sie wird schnell wieder aufgehoben, so daß die Anordnung nach Reparatur und Wiedereinschaltung der Übertragungsstrecke wieder voll funktionsfähig ist.

## Patentansprüche

1. Anordnung zur Strombegrenzung mit einem supraleitfähigen Kabel, das in einem Kryostat angeordnet ist, der eine Außenwand aufweist, welche aus zwei konzentrisch zueinander angeordneten, metallischen Rohren besteht, zwischen denen eine Vakuumisolierung angebracht ist, und der einen Freiraum zum Durchleiten eines Kühlmittels umschließt, in dem das supraleitfähige Kabel angeordnet ist, **dadurch gekennzeichnet,**
- **daß** der Kryostat (KR) eine einen zylindrischen Hohlraum (HR) umschließende Innenwand (IW) aufweist, die ebenfalls aus zwei konzentrisch zueinander angeordneten, metallischen Rohren (4,5) besteht, zwischen denen eine Vakuumisolierung (6) angebracht ist, und die innerhalb der Außenwand (AW) liegt und durch den Freiraum (FR) von derselben getrennt ist,
- **daß** das als Kabel mit kaltem Dielektrikum ausgeführte supraleitfähige Kabel (SK), welches einen supraleitfähigen Leiter (8), ein denselben umgebendes Dietektrikum (9) und einen über demselben angeordneten supraleitfähigen Schirm (10) aufweist, wendelförmig um die Innenwand (IW) herumgewickelt ist, und
- **daß** in dem zylindrischen Hohlraum (HR) ein Eisenkern (7) angeordnet ist.

2. Anordnung nach Anspruch 1, **dadurch gekennzeichnet, daß** die kritische Stromstärke des Leiters (8) des supraleitfähigen Kabels (SK) höher ist als die kritische Stromstärke des Schirms (10) desselben.

## Claims

1. Device for current limiting by use of a superconductive cable which is arranged in a cryostat having an outer wall, which comprises two metallic tubes which are arranged concentrically with respect to one another and between which a vacuum insulation is provided, and which surrounds a free space for a cooling medium to pass through, in which free space the superconductive cable is placed, **characterized in**
- **that** the cryostat (KR) has an inner wall (IW) which surrounds a cylindrical cavity (HR) and which also comprises two metallic tubes (4,5) which are arranged concentrically with respect to one another, between which a vacuum insulation (6) is provided, and which is positioned within the outer wall (AW) and is separated therefrom by the free space (FR),
- **that** the superconductive cable (SK) which has a superconductive conductor (8), a dielectric (9) surrounding the same and a superconductive screen (10) which is provided above the same, is wound in a helical shape around the inner wall (IW), and
- **that** an iron core (7) is arranged in the cylindrical cavity (HR).

2. Device according to claim 1, **characterized in that** the critical current level in the conductor (8) of the superconductive cable (SK) is higher than the critical current level in the screen (10) thereof.

## Revendications

1. Agencement de limitation de courant avec un câble supraconducteur, disposé dans un cryostat comportant une paroi extérieure constituée de deux tubes métalliques disposés de manière concentrique l'un par rapport à l'autre, entre lesquels est placée une isolation à vide entourant un espace libre pour la circulation d'un fluide de refroidissement dans lequel est disposé le câble supraconducteur, **caractérisé en ce que**,
- le cryostat (KR) comporte une paroi intérieure (IW) entourant une cavité cylindrique (HR), constituée également de deux tubes métalliques (4, 5) disposés de manière concentrique l'un par rapport à l'autre, entre lesquels est placée une isolation à vide (6) située à l'intérieur de la paroi extérieure (AW) et séparée de celle-ci par l'espace libre (FR),
- le câble supraconducteur (SK) réalisé sous la forme d'un câble à diélectrique froid, comportant un conducteur supraconducteur (8), un diélectrique (9) encerclant celui-ci et un blindage supraconducteur (10) disposé par-dessus celui-ci, est bobiné en spirale autour de la paroi intérieure (IW), et
- un coeur en fer (7) est disposé dans la cavité cylindrique (HR).

2. Agencement selon la revendication 1, **caractérisé en ce que** l'intensité de courant critique du conducteur (8) du câble supraconducteur (SK) est supérieure à l'intensité de courant critique du blindage (10) de celui-ci.
